(19)

**Europäisches Patentamt**
**European Patent Office**
**Office européen des brevets**

(11) **EP 4 703 743 A1**

(12) **EUROPEAN PATENT APPLICATION**

(43) Date of publication:
**04.03.2026 Bulletin 2026/10**

(51) International Patent Classification (IPC):
**G01R 31/12** (2020.01)

(21) Application number: **24197335.3**

(22) Date of filing: **29.08.2024**

(52) Cooperative Patent Classification (CPC):
**G01R 31/1254; G01R 31/1227**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Aktiengesellschaft**
**80333 München (DE)**

(72) Inventors:
• **G M, Madhu**
  **577002 Davanagere, Karnataka (IN)**
• **MAHAMBREY, Mayur**
  **403507 Bardez, Goa (IN)**
• **JOSHI, Shashank**
  **403602 Goa (IN)**
• **RAJEEV, Jose**
  **682507 Kochi (IN)**

(74) Representative: **Patentanwaltskanzlei WILHELM & BECK**
**Prinzenstraße 13**
**80639 München (DE)**

(54) **SWITCHGEAR SYSTEM AND METHOD FOR MONITORING PARTIAL DISCHARGE ACTIVITY IN ELECTRICAL SWITCHGEAR CABINET APPARATUS**

(57) A switchgear system (1000) and a method (100) for monitoring partial discharge (PD) activity. The method (100) includes receiving a plurality of current transducer signals from the switchgear system (1000) and determining a presence of the PD activity based on an analysis of at least one of the plurality of current transducer signals. The method also includes classifying the at least one current transducer signal into at least one PD category by a trained ML model, in response to determining the presence of the PD activity and estimating a severity of the PD activity by a statistical model, wherein the severity of the PD activity is one of severe, moderate, and low. Further, the method includes displaying a decision on the presence of the PD activity and a severity of the PD activity on a screen of the switchgear system (1000).

FIG 2

EP 4 703 743 A1

**Description**

The present disclosure relates generally to partial discharge in switchgears, and more specifically to a switchgear system and a method for monitoring partial discharge (PD) in an electrical switchgear cabinet apparatus.

Generally, switchgears operate under very high voltages and hence are insulated from its surroundings to prevent any possible damage to life and property of those operating the switchgears. It is configured to provide shielding to the interconnected devices by controlling, metering and regulating flow of electricity in a distribution management system. Medium Voltage Switchgears are prime components in a power distribution network which plays a crucial role in safe and reliable distribution of electrical power from power source to end users. Monitoring and predictive maintenance of the switchgear is necessary to ensure reliable operation of the switchgear and to maintain continuity of power supply without having outages which will otherwise effect revenue of power distribution supplier. Among the different parameters monitored in the switchgears for its reliable operation and to perform predictive maintenance, partial discharge (PD) stands as the critical parameter to be monitored for the continuous monitoring of insulation in the switchgear.

Partial discharge (PD) occurs in an insulation system by localised electrical breakdown of electric insulation materials under high voltage stress. In the PD scenario, few milliamperes of high frequency pulsating current discharges are emitted from a deteriorated area of the insulation when applied voltage is greater than breakdown voltage of the deteriorated area of the insulation. This PD leads to permanent insulation damage if untreated resulting in entire equipment failure. To detect the PD activity, several conventional methods and non-conventional methods are used in industry.

Conventional methods of detecting the PD activity requires removal of the switchgears whose PD activity needs to be accessed and standard IEC 60270 test circuit is used to detect the PD activity and its severity. However, these conventional methods are not preferred for real time monitoring applications as they require the switchgear to be taken out of operation and hence the method may not be accurate and efficient.

Non-conventional methods of detecting the PD activity includes using derived parameters associated with the PD like conduction and irradiated emissions to detect and analyze the PD activity and these methods are also called as real-time monitoring or online methods for PD detection. However, the use of derived parameters may not provide and accurate result on the PD activity and also there is no method currently which performs preventive maintenance operations of the switchgears. Therefore, from a switchgear point of view considering both air insulated switchgear (AIS) and gas insulated switchgear (GIS), there exists a tremendous requirement for a common solution for real time PD activity detection, monitoring, and trend analysis to perform the preventive maintenance operations.

The present disclosure seeks to overcome the above-mentioned challenges by using a switchgear system and method for partial discharge detection, analysis, and monitoring for the switchgear insulation with current transformer (such as for example, a high frequency current transducer (HFCT)) as a sensor for insulation condition monitoring and predictive maintenance application. The proposed method utilizes A8000 family's modular architecture to develop an intelligent electronic device (IED) which can provide PD detection, monitoring, and severity analysis features. The determined information and deducted PD activity data from the PD detection method is sent to a configured cloud for further remote monitoring and trend analysis. Here, PD data is acquired from HFCT sensor to carry out PD detection followed by denoising of the acquired PD signals. Further, programmable digital filter is used to perform filtering on acquired, denoised signals. Then the denoised signals are analyzed to classify it as either a PD signal or No PD signal noise signal. Further, if the PD signal is determined then the PD signal is classified based on a PD type (example corona, internal or surface) and estimate a severity of the PD activity. To develop KPIs which can be used to identify and monitor the PD activity, extract key parameters from the HFCT sensor data and use to plot a PRPD graph and send it to cloud for further analysis.

The object of the present disclosure is achieved by a method for monitoring partial discharge (PD) activity in a switchgear system. The method includes receiving, by an intelligent electronic device (IED) of the switchgear system, a plurality of current transducer signals from the switchgear system and determining a presence of the PD activity based on an analysis of at least one of the plurality of current transducer signals. The method then includes classifying the at least one current transducer signal into at least one PD category by a trained machine learning (ML) model, in response to determining the presence of the PD activity. Further, the method includes estimating a severity of the PD activity by a statistical model, wherein the severity of the PD activity is one of severe, moderate, and low; and displaying a decision on the presence of the PD activity and a severity of the PD activity on a screen of the switchgear system.

In one or more embodiments, receiving the plurality of current transducer signals from the switchgear system includes receiving a current transducer signal of the plurality of current transducer signals and applying a configured delay for receiving a next current transducer signal of the plurality of current transducer signals and receiving the next current transducer signal of the plurality of current transducer signals after the configured delay.

In one or more embodiments, the configured delay is applied between each of the plurality of current transducer signals to realize a first analysing window.

In one or more embodiments, further includes denoising the plurality of current transducer signals to remove noise content from the plurality of current transducer signals, where the denoising is performed using a wavelet based denoising technique; and filtering the plurality of current transducer signals using a configurable digital bandpass filter to remove unwanted frequency components from the plurality of current transducer signals.

In one or more embodiments, classifying the plurality of current transducer signals into the at least one category of the PD activity by the trained ML model includes receiving the plurality of filtered current transducer signals and extracting a set of features from the plurality of filtered current transducer signals. The method also includes inputting the set of extracted features into the trained ML model and classifying the plurality of current transducer signals into the at least one category of the PD activity by the trained ML model.

In one or more embodiments, further includes displaying the at least one category of the PD activity on a screen of the switchgear system.

In one or more embodiments, the at least one category of the PD activity comprises corona partial discharge, internal partial discharge, surface partial discharge and partial discharge absent.

In one or more embodiments, the severity associated with the classified plurality of current transducer signals is estimated by the statistical model based on a pulse amplitude and pulse distribution analysis performed by the statistical model.

In one or more embodiments, further includes validating the presence of the PD activity by dynamically reducing an acquisition window of the plurality of current transducer signals; and displaying the decision on the presence of the PD activity and the severity of the PD activity.

In one or more embodiments, further includes determining a plurality of key performance indicators (KPIs) for each of the plurality of current transducer signals and monitoring the PD activity in the switchgear system based on the plurality of KPIs.

In one or more embodiments, the plurality of KPIs includes the PD activity, the type of the PD activity, the severity of the PD activity, an estimated pulse per acquisition of the plurality of current transducer signals, a mean of the plurality of current transducer signals, a standard deviation of the plurality of current transducer signals, and peak information of the plurality of current transducer signals.

In one or more embodiments, the method further includes determining peak information of each of the plurality of current transducer signals and a time stamp associated with the peak information and determining a phase resolved partial discharge (PRPD) graph using the peak information and the time stamp associated with the peak information of each of the plurality of current transducer signals. The method also includes sending by the switchgear system the PRPD graph to a cloud server and analysing a PD activity trend by the cloud sever based on the PRPD graph.

The object of the present disclosure is further achieved by a switchgear system for monitoring partial discharge (PD) activity. The switchgear system includes a switchgear body, an insulator covering the switchgear body and an intelligent electronic device (IED) for evaluating the PD activity in the switchgear body or the insulator. The IED includes a processor and a memory coupled to the processor, where the memory includes instructions which, when executed by the processor, configures the processor to receive a plurality of current transducer signals from the switchgear system and determine a presence of the PD activity based on an analysis of the received plurality of current transducer signals. The processor is also configured to classify at least one of the current transducer signals into at least one PD category by a trained machine learning (ML) model, in response to determining the presence of the PD activity. Further, the processor is configured to estimate a severity of the PD activity by a statistical model, where the severity of the OD activity is one of severe, moderate, and low; and display a decision on the presence of the PD activity and a severity of the PD activity on a screen of the switchgear system.

Still other aspects, features, and advantages of the disclosure are readily apparent from the following detailed description, simply by illustrating a number of particular embodiments and implementations, including the best mode contemplated for carrying out the disclosure. The disclosure is also capable of other and different embodiments, and its several details may be modified in various obvious respects, all without departing from the scope of the disclosure. Accordingly, the drawings and description are to be regarded as illustrative in nature, and not as restrictive.

A more complete appreciation of the present disclosure and many of the attendant aspects thereof will be readily obtained as the same becomes better understood by reference to the following description when considered in connection with the accompanying drawings:

FIG 1      is a flowchart representation of a method for monitoring partial discharge (PD) activity in a switchgear system, in accordance with one or more embodiments of the present disclosure;

FIG 2      is a block diagram representation of a switchgear system for monitoring the PD activity, in accordance with one or more embodiments of the present disclosure;

FIG 3A      is an exemplary depiction of PD signal acquisition mechanism from a current transducer sensor, in accordance with one or more embodiments of the present disclosure;

FIG 3B      is an exemplary depiction of data set acquired for the PD analysis, in accordance with one or more embodiments of the present disclosure;

FIG 4      is a flowchart representation of a method for data acquisition from a HFCT sensor of the switchgear system, in accordance with one or more embodiments of the present disclosure;

FIG 5      is a flowchart representation of a method for denoising of the data acquired from the HFCT sensor of the switchgear system, in accordance with one or more embodiments of the present disclosure;

FIG 6      is a flowchart representation of a method for filtering of the denoised data, in accordance with one or more embodiments of the present disclosure;

FIG 7      is a flowchart representation of a method for PD activity detection and classification, in accordance with one or more embodiments of the present disclosure;

FIG 8      is a flowchart representation of a method for determining a severity of the PD activity, in accordance with one or more embodiments of the present disclosure;

FIG 9      is a flowchart representation of a method for peak detection and sorting, in accordance with one or more embodiments of the present disclosure;

FIG 10      is a graph plot representing a phase resolved partial discharge (PRPD) for peak information, in accordance with one or more embodiments of the present disclosure; and

FIG 11      is a flowchart representation of a method for PD analysis validation by dynamically varying the PD signal acquisition delay, in accordance with one or more embodiments of the present disclosure.

Various embodiment-s are described with reference to the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

Examples of a method and switchgear system for monitoring partial discharge (PD) activity are disclosed herein. In the following description, for the purposes of explanation, numerous specific details are set forth in order to provide a thorough understanding of the embodiments of the disclosure. It is apparent, however, to one skilled in the art that the embodiments of the disclosure may be practiced without these specific details or with an equivalent arrangement. In other instances, well-known structures and devices are shown in block diagram form in order to avoid unnecessarily obscuring the embodiments of the disclosure.

High-tension electrical switchgear cabinet apparatus is a huge cabinet which carries load directly to customer power supply. Therefore, an operating status of the electrical switchgear cabinet directly impacts customer power supply and reliability of the same. For the electrical switchgear cabinet needs to run for a very long duration of time and the same is inevitably. As a result, insulation degradation occurs due to aging, dampness, mechanical damage etc. Conventional methods and systems for detecting PD activity and to provide the real time monitoring and trend analysis, are generally expensive solutions. There are also methods to identify a PD type using signal processing techniques. Machine learning techniques are also being applied to classify the PD type. However, it has been identified that very little research has been carried out to develop an entire system for PD monitoring, detection, and analysis. Conventional methods and systems may not be providing high flexibility to monitor multiple switchgears and provide cost effective solution.

Unlike to the conventional methods and systems, the proposed solution detects the PD activity, classifies the PD activity and estimates a severity of the PD activity. Hence the proposed solution provides a comprehensive solution to the PD activity monitoring process and is a very flexible and cost-effective solution.

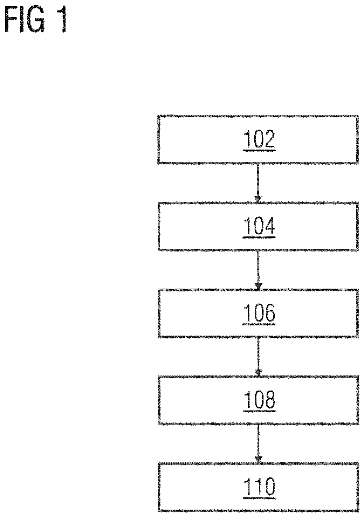

Referring now to FIG 1, illustrated is a flowchart of a method (as represented by reference numeral 100) for monitoring partial discharge (PD) activity in a switchgear system 1000, in accordance with an embodiment of the present disclosure. As used herein, the Partial Discharge (PD) is a phenomenon that occurs in an insulation system due to insulation deterioration caused by factors such as ageing, improper installation, manufacturing defects, or any other physical damage wherein, few milliamperes of high frequency pulsating current discharges are emitted from the deteriorated area when the applied voltage is more than the breakdown voltage of the damaged/deteriorated insulation.

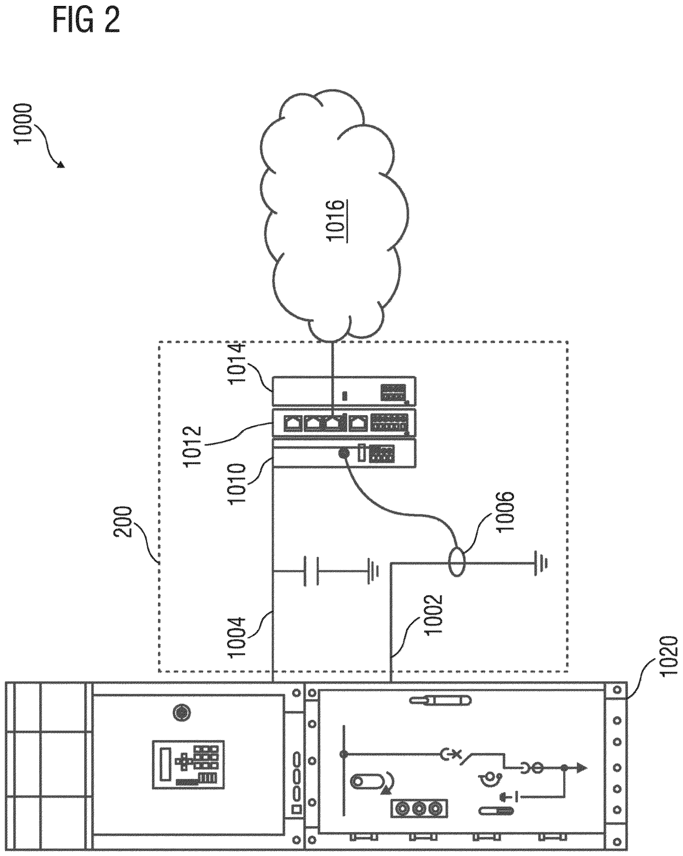

Referring to FIGS 1 and 2 in combination, the various steps of the method 100 as described hereinafter may be executed in the switchgear system 1000, for - for monitoring PD activity in the switchgear system 1000. For purposes of the present disclosure, the measuring of the PD in the switchgear system 1000 is well known in art. However, there are a number of factors which impact the measurement of the PD. It may be appreciated that although the method 100 is illustrated and described as a sequence of steps, it may be contemplated that various embodiments of the method 100 may be performed in any order or a combination and need not include all of the illustrated steps.

In embodiments of the present disclosure, at step 102, the method 100 includes the IED 200 of the switchgear system 1000 receiving multiple current transducer signals from the switchgear system 1000. Here, the IED 200 a single current transducer signal and applies a configured delay for receiving a next current transducer signal and thereby receives the entire set of signals that needs to be analysed. The configured delay is applied between each of the current transducer signals to realize a first analysing window. The analysing window can be for example 1 hour or even a day's time.

In embodiments of the present disclosure, at step 104, the method 100 includes determining a presence of the PD activity based on an analysis of at least one of the plurality of current transducer signals.

In embodiments of the present disclosure, at step 106, the method 100 includes classifying the at least one current transducer signal into at least one PD category by a trained machine learning (ML) model, on determining the presence of the PD activity. This includes the IED 200 receives the filtered current transducer signals and extracts a set of features from the filtered current transducer signals. Further, the set of extracted features into are input to a trained ML model. Further, once the classification is completed, then the IED 200 may display the category of the PD activity on a screen of the switchgear system 1000. The category of the PD activity can be corona partial discharge, internal partial discharge, surface partial discharge or partial discharge absent.

In embodiments of the present disclosure, at step 108, the method 100 includes estimating a severity of the PD activity by a statistical model, wherein the severity of the PD activity is one of severe, moderate, and low. The severity associated with the classified current transducer signals is estimated by the statistical model based on a pulse amplitude and pulse distribution analysis performed by the statistical model.

In embodiments of the present disclosure, at step 110, the method 100 includes displaying a decision on the presence of the PD activity and a severity of the PD activity on a screen of the switchgear system 1000. Further, the method also includes determining key performance indicators (KPIs) for the current transducer signals and monitoring the PD activity in the switchgear system 1000 based on the plurality of KPIs. The KPIs can be for example but not limited to the PD activity, the type of the PD activity, the severity of the PD activity, an estimated pulse per acquisition of the plurality of current transducer signals, a mean of the plurality of current transducer signals, a standard deviation of the plurality of current transducer signals, and peak information of the plurality of current transducer signals.

Further, the method also includes determining peak information of the current transducer signals and a time stamp associated with the peak information and determining a phase resolved partial discharge (PRPD) graph using the peak information and the time stamp associated with the peak information. Then the IEO 200 sends the PRPD graph to a cloud server 1016 where it can analysed for getting a PD activity trend.

FIG 2 is a block diagram representation of a switchgear system 1000 for monitoring the PD activity, in accordance with one or more embodiments of the present disclosure. Referring to the FIG. 2, the switchgear system 1000 includes an intelligent electronic device (IED) 200 which is connect to a switchgear body 1020 or an insulator covering the switchgear body 1020. The IED 200 is used for monitoring the PD activity in the switchgear body 1020 or the insulator.

The IED 200 includes a partial discharge (PD) acquisition module 1010 connected with a substation automation module 1012 and a power supply 1014 for performing the PD detection, the monitoring, and the analysis. The IEO 200 provides real time insulation monitoring and predictive maintenance with early warning indications of the insulation deterioration in the switchgear body 1020.

The PD acquisition module 1010 includes a current transducer input channel 1006 and a synchronization or reference voltage input channel 1004 with a common earth line 1002. The current transducer input channel 1006 acquires data from a current transducer which can be for example but not limited to a High Frequency Current Transformer (HFCT) sensor for detecting a High Frequency Current (HFC) signal. The HFC signal indicates the partial discharge activity in the electrical switchgear system 1000. The HFCT sensor data is sampled at 125 MSPS, signal conditioned, processed, and used to detect the PD presence. The reference voltage channel is used to trigger the HFCT signal acquisition one full cycle of 50 Hz needs to be sampled. The sampling rate of the voltage reference channel would be 4 KSPS. Further, KPIs are derived from the acquired signal which is sent to the cloud server 1016 for trend analysis. The overall monitoring of the PD activity is done by both local application in the substation automation module 1012 and through the cloud server 1016 from a power management platform.

The IEO 200 initially acquires 12 signals from the HFCT sensor with a delay of 1 hour between each acquisition making the analyzing window at half day basis. The 12 signals are analyzed individually to qualify for PD activity. Further, each signal is first denoised and then passed through a configurable band pass filter to remove any noise content. An extreme gradient boost machine learning model is developed to classify the HFCT signal to either corona, internal, surface, no PD signal or combination of the above. Once the PD is detected and a type of the PD is identified, a severity of the PD activity is computed by applying a statistical approach using the novel hybrid pulse distribution and pulse count analysis. Upon computing the severity, 100 peak points of the signal along with its timestamp / phase angle information is sorted to be stored in the cloud for further analysis. Once the analysis of all 12 signals is done, and if 60% of the signals qualify for the PD activity, then PD presence is identified. To validate the PD presence and its severity, the acquisition window is reduced dynamically from 30min to 5 minutes and PD event is validated to indicate the PD activity and its severity. Finally, the computed data from the PD acquisition module (KPIs) is sent to the substation automation module 1012 to display it in a local application and uploaded to the cloud server 1016 for remote monitoring and analysis.

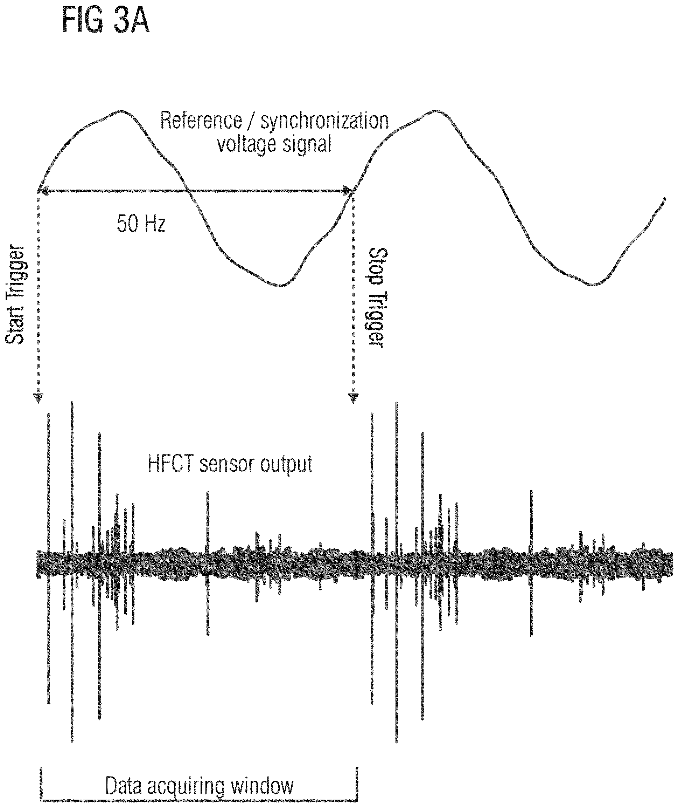

FIG 3A is an exemplary depiction of PD signal acquisition mechanism from a current transducer sensor, in accordance with one or more embodiments of the present disclosure. Referring to the FIG. 3A, the process of acquisition of the signals for analysis is provided. Consider that the current transducer is a high frequency current transducer (HFCT) sensor and a HFCT sensor signal is acquired based on the triggered mechanism with respect to the reference voltage signal. Consider that 2.5e6 (2500000) samples are acquired to make a 20 mS acquisition window (1, 50 Hz Cycle) from the zero crossing of the reference voltage.

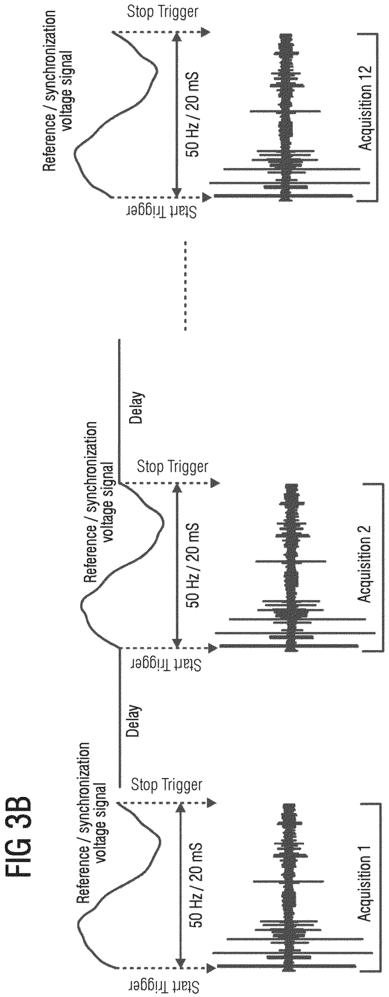

FIG 3B is an exemplary depiction of data set acquired for the PD analysis, in accordance with one or more embodiments of the present disclosure. Referring to the FIG. 3B, in conjunction with the FIG. 3B, after the acquisition of the signal, a configured delay is applied for the next data acquisition as shown in the FIG. 3B. In the example considered here, a total of 12 data acquisitions are performed to create a single dataset for PD activity analysis. These signals are used to run the PD detection algorithm.

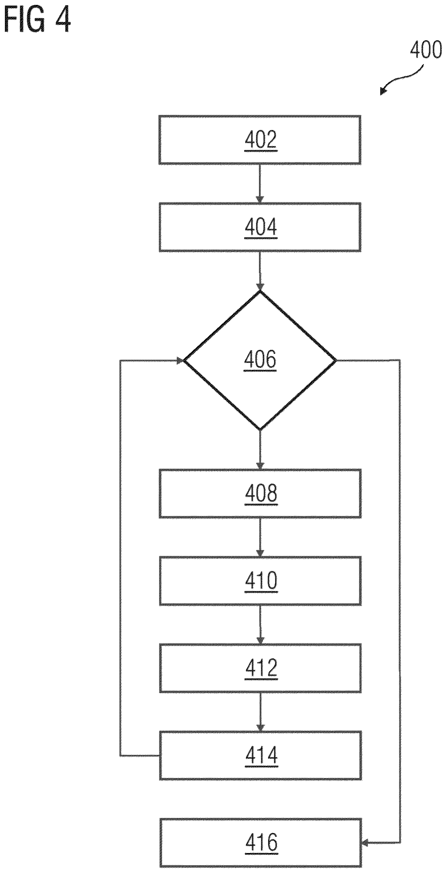

FIG 4 is a flowchart representation of a method 400 for data acquisition from the HFCT sensor 106 of the switchgear system 1000, in accordance with one or more embodiments of the present disclosure. Referring to the FIG. 4, the data set creation for the PD activity analysis from the HFCT sensor 106 is described.

At step 402, the IED 200 reads or acquires multiple parameters such as a reference voltage, HFCT sensor 106 output and the configured delay. Further, at step 404, the IEO 200 sets up a zero-crossing trigger and at step 406, i=0, i<12, i++ is the condition used for the total of 12 data acquisitions.

At step 408, the IEO 200 captures the HFCT sensor signal between a start and a stop trigger and at step 410 save the captured signal in a memory of the IED 200. Further, at step 412 the IED 200 increments to captures the next signal and adds a delay and keeps repeating the step until all the 12 signals are acquired.

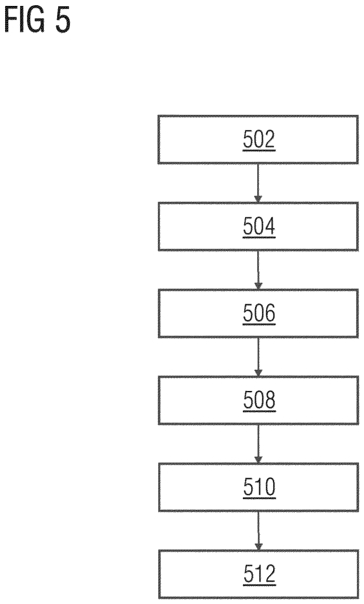

FIG 5 is a flowchart representation of a method for denoising of the data acquired from the HFCT sensor of the switchgear system, in accordance with one or more embodiments of the present disclosure. Referring to the FIG. 5, after the acquisition of the signal is done, the acquired signals are then processed through the denoising logic. Wavelet based denoising of signals is designed to remove the noise content without reducing the signal content.

The following steps are used to process the PD signals for denoising. At step 502 the IED 200 acquires the PD signal and at step 504, the IED 200 performs the discrete wavelet transform using scaling functions such as for example but not limited to Symlet 8. At step 506, the IED 200 dets the thresholding value for Bayes thresholding. Further, at step 508, the IED 200 computes the threshold for each wavelet co-efficient using median rule. At step 510, the IED 200 then applies the Bayes thresholding to the wavelet co-efficient and at step 512 reconstructs the signal from denoised wavelet co-efficient.

Considering the maximum frequency of 30 MHz as the signal of interest, and the PD signals to be spiky, the mother wavelet is chosen to be symlet 8. Similarly, for thresholding of the wavelet transforms, the Bayes thresholding is applied for computing the wavelet co-efficient using the median rule. Then the co-efficient obtained after thresholding are used to reconstruct the denoised signal.

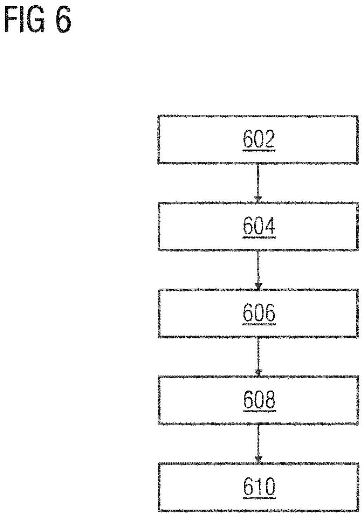

FIG 6 is a flowchart representation of a method for filtering of the denoised data, in accordance with one or more embodiments of the present disclosure. Referring to the FIG. 6, after the signals are denoised, the signals are processed through a configurable digital bandpass filter to remove the other (not interested) frequency components from the acquired PD signals. A digital FIR filter is designed whose parameters can be configured based on the configuration input file to set the filtering parameters.

The method for filtering the denoised signal includes at step 602 the IED 200 acquiring the filter parameters and at step 604 the IED 200 acquires the denoised signal. Further, at step 606, the IED 200 sets the filter parameters and further at step 608 configures the FIR filer. At step 610, the IED 200 filters the signal and removes the unwanted components in the signal. Considering the signals interest between 3 MHz to 30 MHz, the bandpass filtering configuration can be varied to analyze a narrow band frequency component to the wide band frequency components.

A 4th order FIR filter is designed to have a sharp cut off slope in the frequency plot. The passband ripple is considered to be 0.1 dB and stop band attenuation to be 60 dB. The coefficients for the FIR filter are designed using the hamming window technique. This designed filter will take the time series data and filter out the components with respect to the lower and upper cross over frequency whose input output.

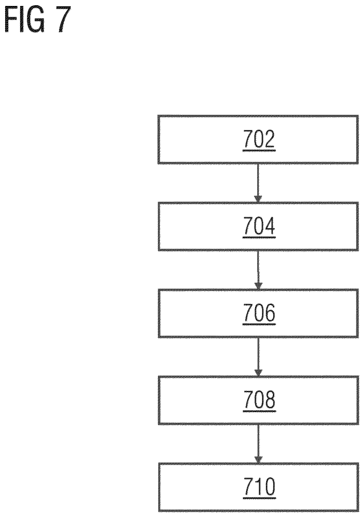

FIG 7 is a flowchart representation of a method for PD activity detection and classification, in accordance with one or more embodiments of the present disclosure. Referring to the FIG. 7, an extreme Gradient Boosting model is used in the proposed solution for the PD activity detection and classification. The XG boost model is a machine learning model based on the gradient boosted decision trees. Here, the decision trees are created in a sequential form which can be used to classify the signals. The XG boost model has been developed to detect the PD and to classify the PD activity into corona, internal, surface and their combination.

The XG boost model is designed using the below mentioned steps:

1. Acquisition of the PD signal data and creating the dataset of PD activity with different labels.
2. Preprocess the data acquired by applying data cleaning, normalization and feature extraction and to make the data ready for training.
3. Extracting the features from the PD data. The features used for training the XG boost model are: outlier count, outlier count left, outlier count right, RMS of the signal, standard deviation, maximum of the signal, minimum of the signal, outlier standard deviation, quantile of outlier of left half of signal at 25%, quantile of outlier of left half of signal at 50%, quantile of outlier of left half of signal at 75%, quantile of outlier of right half of signal at 25%, quantile of outlier of right half of signal at 50%, quantile of outlier of right half of signal at 75%, partial discharge and standard difference

4. The dataset is split into training, validation and testing sets. The training dataset is used for training the XG boost model, the validation set of data is used for hyper parameter tuning, and the testing set is used for model test evaluation.

5. Each dataset is again classified as No PD data, Surface PD, Corona PD, Internal PD, Surface+Internal PD, Internal+Corona PD and Corona+Surface PD classes.

6. This data is then used to train the XG boost model with optimal hyperparameters (learning rate, maximum tree depth and number of estimators).

7. The trained XG boost model is then tuned for optimal hyperparameters.

8. The trained XG boost model is then tested for its accuracy, precision, recall F1 score and ROC curve.

9. Repeat the 3-7 steps to achieve the required accuracy and precision by ideating the features and other parameters.

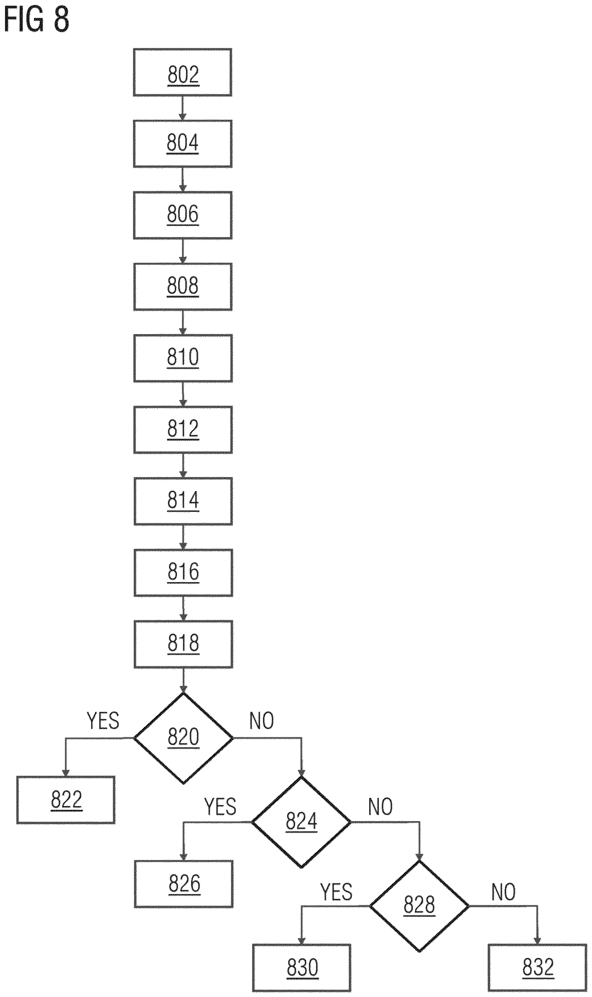

The trained model is then used for the PD detection and classification with the denoised and filtered signal as input. The flowchart of the algorithm detecting the PD signal is as illustrated in Fig. 8. The output of the model will be the identified class which gives the information of whether the signal is PD or No PD and its type.

At step 702, the IED 200 acquires the filtered signal and at step 704 the IEO 200 determines the features from the time series signal. Further, at step 706, the determines features are used for training the XG boost model. The XG boost model then at step 708 is used to identify the class of the signal and at step 710 the IED 200 displays the identified class on the screen of the IED 200.

FIG 8 is a flowchart representation of a method for determining a severity of the PD activity, in accordance with one or more embodiments of the present disclosure. Referring to the FIG. 8, the IED 200 after having determined the presence of the PD signal and a type of the OD signal, proceeds to determine the severity of the PD activity. Conventionally, the charge accumulated in the PD signal is estimated to calculate the severity. However, with the non-conventional method of using HFCT sensor to measure the PD current, the PD current which flows through the earth line tends to dampen out over the line before reaching the sensor point making the estimated charge to be lesser than the actual charge in the PD activity. Therefore, a statistical method is used for estimating the severity of the PD signal where the PD pulse amplitude and PD pulse distribution analysis is carried out to determine the severity.

At step 802, the IEO 200 acquires the filtered signal and at step 804 computes the mean, standard deviation of the signal. Further, at step 806 the IED 200 configures the threshold level. The mean value of the signal and standard deviation of the signal is computed to decide the threshold levels.

Based on the threshold levels the sum of the signal points that cross each threshold values are computed to calculate severe, moderate, and low values.

Therefore, at step 806 the thresholds are provided as:

$$\text{Threshold 1} = \text{mean} + 2 \ * \ \text{std deviation}$$

$$\text{Threshold 2} = \text{mean} + 4 \ * \ \text{std deviation}$$

$$\text{Threshold 3} = \text{mean} + 6 \ * \ \text{std deviation}$$

Further, at step 810, the IED 200 determines pulse count of the signal above threshold level. Therefore, based on the threshold levels the sum of the signal points that cross each threshold values are computed to calculate severe, moderate and low values. Then the overall pulse count of the PD signal is computed with the configured threshold level. At step 812, the signal amplitudes = abs (signal) is used to determine the severity of the PD signal detected.

$$\text{Severe} = \frac{sum\ (signal\ amplitudes > Threshold\ 3)}{total\ length\ of\ signal} \qquad 814$$

$$\text{Moderate} = \frac{sum\ (signal\ amplitudes > Threshold\ 2)}{total\ length\ of\ signal} \qquad 816$$

$$\text{Low} = \frac{sum\ (signal\ amplitudes > Threshold\ 1)}{total\ length\ of\ signal} \qquad 818$$

At step 820, if the severe value is > 0.1 and pulse count is >1000, the PD signals severity is estimated to be severe (822).

At step 824, if the severe value >0.05 ‖ moderate value > 0.1 & pulse count >500, the PD signals severity is estimated to be moderate (826).

At step 828, if the severe value >0.02 ∥ moderate value >0.05 & pulse count is >100, the PD signals severity is estimated to be Low (830) and else PD signal severity is estimated to be normal (832).

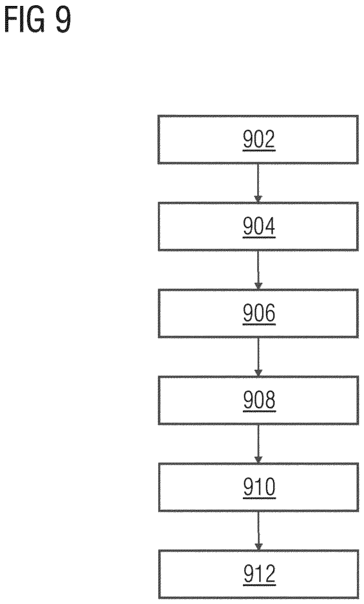

FIG 9 is a flowchart representation of a method for peak detection and sorting, in accordance with one or more embodiments of the present disclosure. Referring to the FIG. 9, consider that the PD activity is detected in the switchgear system 1000. Once the PD activity is detected, identified its type and severity, then the maximum 100 peaks from the acquisition is sorted out for plotting the PRPD graph for the analysis and also for storing it in cloud for trend analysis. The peak detection method is used to detect the peak information and its time stamp. A baseline-based approach is used to design the peak detection method with base line value equal to mean of the signal.

At step 902, the IEO 200 acquires the filtered signal and at step 904 it determines the mean value of the filtered signals. At step 906 the IED 200 identifies the baseline as the man value of the filtered signals. Further, at step 908, the IED 200 determines peaks of signal with timestamp value of where the peaks are occurring in the signal. At step 910, the IED 200 sorts out the peaks of the signals in the descending order and at step 912 sorts the first 100 peaks with the timestamp.

Further, the IED 200 also determines a set of KPIs with each dataset. The key performance indicators are designed to analyze the PD activity. The KPIs determined are for example but not limited to PD activity, PD Type, PD severity, estimated pulse per acquisition, mean of the acquisition, standard deviation of the acquisition and peak information's of the acquisition.

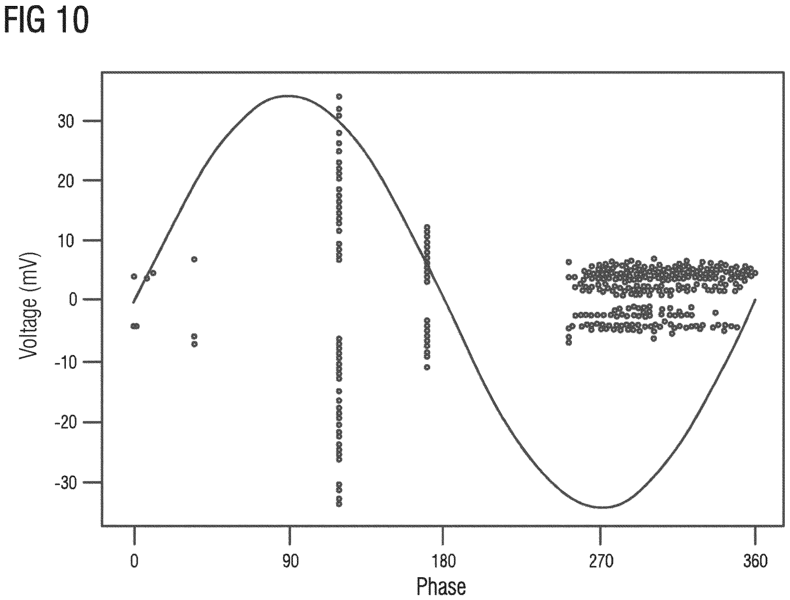

FIG 10 is a graph plot representing a phase resolved partial discharge (PRPD) for peak information, in accordance with one or more embodiments of the present disclosure. Referring to the FIG. 10, the PRPD graph is plotted with the peak information from the 12 acquisitions in one analysis. From the 12 acquisitions considered for the PD detection, each acquisition will result in a 100 peak information which is used to plot the phase resolved partial discharge graph. The time series information is transformed into the phase dependent information (20ms to 360degree) so that voltage vs phase.

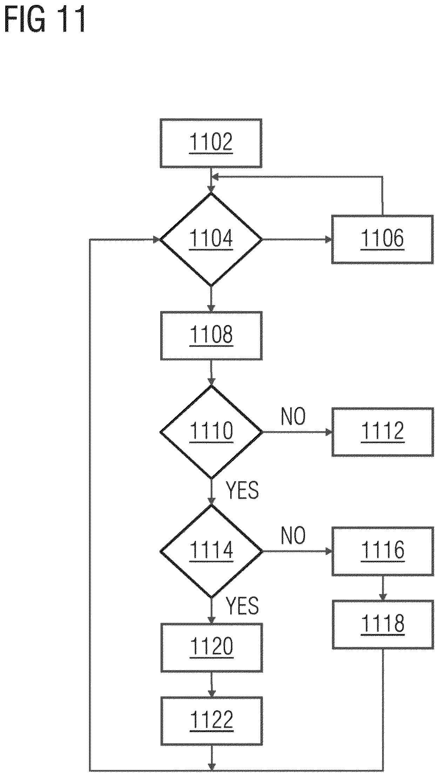

FIG 11 is a flowchart representation of a method for PD analysis validation by dynamically varying the PD signal acquisition delay, in accordance with one or more embodiments of the present disclosure. Referring to the FIG. 11, after the analysis results in the PD detection and the identification of the severity of the PD activity is computed, the time delay between the acquisitions for the next analysis is reduced to validate the detected PD and its severity. At step 1102 the validation process begins. At step 1104 the initialization process is performed where i = 0, i < 60; i++ and at step 1106 reset PD validation and timer.

At step 1108, the PD validation window is determined as i. Further, at step 1110, the IED 200 determines if the PD is detected or not. If the PD is not detected, then at 1112 no further action is taken. At step 1114, on determining that the presence of the PD is detected, the PD signal is checked for validation. At step 1116, on determining that the PD signal is not validated, the time delay will be dynamically reduced to 5 min from the 60 min window and new 12 acquisitions will be performed for the next analysis. If the PD detection is already validated, then at step 1120, the delay between the acquisitions will be kept 60 min for next 60 analysis (1 month) before validating again.

While the present disclosure has been described in detail with reference to certain embodiments, it should be appreciated that the present disclosure is not limited to those embodiments. In view of the present disclosure, many modifications and variations would be present themselves, to those skilled in the art without departing from the scope of the various embodiments of the present disclosure, as described herein. The scope of the present disclosure is, therefore, indicated by the following claims rather than by the foregoing description. All changes, modifications, and variations coming within the meaning and range of equivalency of the claims are to be considered within their scope.

Reference Numerals

| | |
|---|---|
| method | 100 |
| step | 102 |
| step | 104 |
| step | 106 |
| step | 108 |
| step | 110 |
| IED | 200 |
| switchgear system | 1000 |
| common earth line | 1002 |
| synchronization or reference voltage input channel | 1004 |
| current transducer input channel | 1006 |
| partial discharge (PD) acquisition module | 1010 |
| substation automation module | 1012 |
| power supply | 1014 |

(continued)

| | |
|---|---|
| cloud server | 1016 |
| switchgear body | 1020 |
| method | 400 |
| step | 402 |
| step | 404 |
| step | 406 |
| step | 408 |
| step | 410 |
| step | 412 |
| step | 502 |
| step | 504 |
| step | 506 |
| step | 508 |
| step | 510 |
| step | 602 |
| step | 604 |
| step | 606 |
| step | 608 |
| step | 610 |
| step | 702 |
| step | 704 |
| step | 706 |
| step | 708 |
| step | 710 |
| step | 802 |
| step | 804 |
| step | 806 |
| step | 808 |
| step | 810 |
| step | 812 |
| step | 814 |
| step | 816 |
| step | 818 |
| step | 820 |
| step | 822 |
| step | 824 |
| step | 826 |
| step | 828 |
| step | 830 |
| step | 832 |
| step | 902 |
| step | 904 |
| step | 906 |
| step | 908 |
| step | 910 |
| step | 912 |
| step | 1102 |
| step | 1104 |
| step | 1106 |
| step | 1108 |
| step | 1110 |
| step | 1112 |

(continued)

| step | 1114 |

**Claims**

1.  A method (100) for monitoring partial discharge (PD) activity in a switchgear system (1000), the method (100) comprising:

    receiving, by an intelligent electronic device (IED) (200) of the switchgear system (1000), a plurality of current transducer signals from the switchgear system (1000);
    determining, by the IED (200), a presence of the PD activity based on an analysis of at least one of the plurality of current transducer signals;
    **characterized by:**

    classifying, by the IED (200), the at least one current transducer signal into at least one PD category by a trained machine learning (ML) model, in response to determining the presence of the PD activity;
    estimating, by the IED (200), a severity of the PD activity by a statistical model, wherein the severity of the PD activity is one of severe, moderate, and low; and
    displaying, by the IED (200), a decision on the presence of the PD activity and a severity of the PD activity on a screen of the switchgear system (1000).

2.  The method (100) according to claim 1, wherein receiving, by the IED (200), the plurality of current transducer signals from the switchgear system (1000) comprises:

    receiving, by the IED (200), a current transducer signal of the plurality of current transducer signals;
    applying, by the IED (200), a configured delay for receiving a next current transducer signal of the plurality of current transducer signals; and
    receiving, by the IED (200), the next current transducer signal of the plurality of current transducer signals after the configured delay.

3.  The method (100) according to claim 2, wherein the configured delay is applied between each of the plurality of current transducer signals to realize a first analysing window.

4.  The method (100) according to claim 2, further comprises:

    denoising, by the IED (200), the plurality of current transducer signals to remove noise content from the plurality of current transducer signals, wherein the denoising is performed using a wavelet based denoising technique; and
    filtering, by the IED (200), the plurality of current transducer signals using a configurable digital bandpass filter to remove unwanted frequency components from the plurality of current transducer signals.

5.  The method (100) according to claim 1, wherein classifying, by the IED (200), the plurality of current transducer signals into the at least one category of the PD activity by the trained ML model comprises:

    receiving, by the IED (200), the plurality of filtered current transducer signals;
    extracting, by the IED (200), a set of features from the plurality of filtered current transducer signals;
    inputting, by the IED (200), the set of extracted features into the trained ML model; and
    classifying, by the IED (200), the plurality of current transducer signals into the at least one category of the PD activity by the trained ML model.

6.  The method (100) according to claim 5, further comprises:
    displaying, by the IED (200), the at least one category of the PD activity on a screen of the switchgear system (1000).

7.  The method (100) according to claim 1, wherein the at least one category of the PD activity comprises corona partial discharge, internal partial discharge, surface partial discharge and partial discharge absent.

8.  The method (100) according to claim 1, wherein the severity associated with the classified plurality of current transducer signals is estimated by the statistical model based on a pulse amplitude and pulse distribution analysis performed by the statistical model.

9. The method (100) according to claim 1, further comprises:

   validating, by the IED (200), the presence of the PD activity by dynamically reducing an acquisition window of the plurality of current transducer signals; and
   displaying, by the IED (200), the decision on the presence of the PD activity and the severity of the PD activity.

10. The method (100) according to claim 1, further comprises:

    determining, by the IED (200), a plurality of key performance indicators (KPIs) for each of the plurality of current transducer signals; and
    monitoring, by the IED (200), the PD activity in the switchgear system (1000) based on the plurality of KPIs.

11. The method (100) according to claim 10, wherein the plurality of KPIs comprises the PD activity, the type of the PD activity, the severity of the PD activity, an estimated pulse per acquisition of the plurality of current transducer signals, a mean of the plurality of current transducer signals, a standard deviation of the plurality of current transducer signals, and peak information of the plurality of current transducer signals.

12. The method (100) according to claim 1, further comprises:

    determining, by the IED (200), peak information of each of the plurality of current transducer signals and a time stamp associated with the peak information;
    determining, by the IED (200), a phase resolved partial discharge (PRPD) graph using the peak information and the time stamp associated with the peak information of each of the plurality of current transducer signals;
    sending, by the IED (200), by the switchgear system (1000) the PRPD graph to a cloud server (1016); and
    analysing a PD activity trend by the cloud sever based on the PRPD graph.

13. A switchgear system (1000) for monitoring partial discharge (PD)activity, the switchgear system (1000) comprising:

    a switchgear body (1020);
    an insulator covering the switchgear body (1020); and
    an intelligent electronic device (IED) (200) for monitoring the PD activity in the switchgear body (1020) or the insulator and wherein the IED (200) comprises:

       a processor (204); and
       a memory (206) coupled to the processor (204), wherein the memory (206) comprises instructions which, when executed by the processor (204), configures the processor (204) to:

          receive a plurality of current transducer signals from the switchgear system (1000);
          determine a presence of the PD activity based on an analysis of the received plurality of current transducer signals;
          **characterized by:**

             classify the plurality of current transducer signals into at least one PD category by a trained machine learning (ML) model, in response to determining the presence of the PD activity;
             estimate a severity of the PD activity by a statistical model, wherein the severity of the OD activity is one of severe, moderate, and low; and
             display a decision on the presence of the PD activity and a severity of the PD activity on a screen of the switchgear system (1000).

14. A computer program product, comprising computer program code which, when executed by a processor (204), cause the processor (204) to carry out the method (100) of one of the claims 1 to 12.

15. A computer-readable medium comprising a computer program product comprising computer program code which, when executed by a processor (204), cause the processor (204) to carry out the method (100) of one of the claims 1 to 12.

FIG 1

# FIG 2

FIG 3A

# FIG 3B

Reference / synchronization voltage signal

Start Trigger

Stop Trigger

Delay

50 Hz / 20 mS

Acquisition 1

Reference / synchronization voltage signal

Start Trigger

Stop Trigger

Delay

50 Hz / 20 mS

Acquisition 2

Reference / synchronization voltage signal

Start Trigger

Stop Trigger

50 Hz / 20 mS

Acquisition 12

EP 4 703 743 A1

FIG 4

FIG 5

```
┌─────────────────────┐
│         502         │
└─────────────────────┘
           │
           ▼
┌─────────────────────┐
│         504         │
└─────────────────────┘
           │
           ▼
┌─────────────────────┐
│         506         │
└─────────────────────┘
           │
           ▼
┌─────────────────────┐
│         508         │
└─────────────────────┘
           │
           ▼
┌─────────────────────┐
│         510         │
└─────────────────────┘
           │
           ▼
┌─────────────────────┐
│         512         │
└─────────────────────┘
```

FIG 6

```
        ┌─────────────────┐
        │       602       │
        └────────┬────────┘
                 │
                 ▼
        ┌─────────────────┐
        │       604       │
        └────────┬────────┘
                 │
                 ▼
        ┌─────────────────┐
        │       606       │
        └────────┬────────┘
                 │
                 ▼
        ┌─────────────────┐
        │       608       │
        └────────┬────────┘
                 │
                 ▼
        ┌─────────────────┐
        │       610       │
        └─────────────────┘
```

FIG 7

```
┌─────────────────────┐
│         702         │
└─────────────────────┘
           │
           ▼
┌─────────────────────┐
│         704         │
└─────────────────────┘
           │
           ▼
┌─────────────────────┐
│         706         │
└─────────────────────┘
           │
           ▼
┌─────────────────────┐
│         708         │
└─────────────────────┘
           │
           ▼
┌─────────────────────┐
│         710         │
└─────────────────────┘
```

# FIG 8

FIG 9

```
┌──────────────────┐
│       902        │
└──────────────────┘
         │
         ▼
┌──────────────────┐
│       904        │
└──────────────────┘
         │
         ▼
┌──────────────────┐
│       906        │
└──────────────────┘
         │
         ▼
┌──────────────────┐
│       908        │
└──────────────────┘
         │
         ▼
┌──────────────────┐
│       910        │
└──────────────────┘
         │
         ▼
┌──────────────────┐
│       912        │
└──────────────────┘
```

FIG 10

EP 4 703 743 A1

# FIG 11

```
              ┌──────────┐
              │   1102   │
              └────┬─────┘
                   │
                   ▼
              ◇ 1104 ◇ ──────────────►  ┌──────────┐
                   │                     │   1106   │
                   │                     └──────────┘
                   ▼
              ┌──────────┐
              │   1108   │
              └────┬─────┘
                   ▼
              ◇ 1110 ◇ ──── NO ───►  ┌──────────┐
                   │                  │   1112   │
                  YES                 └──────────┘
                   ▼
              ◇ 1114 ◇ ──── NO ───►  ┌──────────┐
                   │                  │   1116   │
                  YES                 └────┬─────┘
                   ▼                       ▼
              ┌──────────┐            ┌──────────┐
              │   1120   │            │   1118   │
              └────┬─────┘            └──────────┘
                   ▼
              ┌──────────┐
              │   1122   │
              └──────────┘
```

Europäisches
Patentamt
European
Patent Office
Office européen
des brevets

# EUROPEAN SEARCH REPORT

**Application Number**

EP 24 19 7335

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GOVINDARAJAN SUGANYA ET AL: "Development of Hypergraph Based Improved Random Forest Algorithm for Partial Discharge Pattern Classification", IEEE ACCESS, IEEE, USA, vol. 9, 24 December 2020 (2020-12-24), pages 96-109, XP011829852, DOI: 10.1109/ACCESS.2020.3047125 [retrieved on 2021-01-04] * Page 96: Introduction - Page 97: LH col., 2nd paragraph. Pages 99-100, 105-107: Case Study II.; figures 4-6 * ----- | 1-15 | INV. G01R31/12 |

**TECHNICAL FIELDS SEARCHED (IPC)**

G01R

The present search report has been drawn up for all claims

| Place of search | Date of completion of the search | Examiner |
|---|---|---|
| Munich | 12 February 2025 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)